# EUROPÄISCHE PATENTSCHRIFT

(11) **EP 0 809 360 B1**
(45) Veröffentlichungstag und Bekanntmachung des Hinweises auf die Patenterteilung: **02.08.2000**
(21) Anmeldenummer: 97107428.1
(22) Anmeldetag: 06.05.1997
(51) Int. Cl.: H03K 17/082, H03K 17/16

(54) **Integrierte Schaltungsanordnung mit einem als npn-Transistor ausgebildeten Open-Collector-Transistor**
Integrated circuit with an NPN-type open collector transistor
Circuit intégré avec un transistor à collecteur ouvert du type NPN

(30) Priorität: 22.05.1996 DE 19620564
(43) Veröffentlichungstag der Anmeldung: 26.11.1997
(73) Patentinhaber: TEMIC Semiconductor GmbH, 74072 Heilbronn (DE)
(72) Erfinder: Koch, Anton, 74834 Elztal-Auernbach (DE)
(74) Vertreter: Maute, Hans-Jürgen, Dipl.-Ing.

(56) Entgegenhaltungen:
- GB-A- 2 204 445
- US-A- 4 965 466
- PATENT ABSTRACTS OF JAPAN vol. 016, no. 088 (E-1173), 4.März 1992 & JP 03 270407 A (FUJITSU LTD;OTHERS: 01), 2.Dezember 1991,
- PATENT ABSTRACTS OF JAPAN vol. 006, no. 218 (E-139), 2.November 1982 & JP 57 121321 A (YAMATAKE HONEYWELL KK), 28.Juli 1982,
- GLITSCH, R.: "Kurzschlussfester "Open-Collector"-Ausgang mit niedriger Sättigungsspannung" ELEKTRONIK, Bd. 34, Nr. 22, Oktober 1985, Seite 115 XP002062588

## Beschreibung

Die Erfindung betrifft eine integrierte Schaltungsanordnung mit einem als npn-Transistor ausgebildeten Open-Collector-Transistor dessen Kollektor mit einem Open-Collector-Ausgang der Schaltungsanordnung verbunden ist und dessen Emitter mit einem Masseanschluß der Schaltungsanordnung verbunden ist, wobei am Open-Collector-Ausgang eine Ausgangsspannung ansteht.

Eine derartige Schaltungsanordnung ist aus der Literaturstelle Tietze/Schenk: "Halbleiter-Schaltungstechnik", Springer-velag, Berlin, 1978, Seite 161 bekannt. Die dort beschriebene Schaltungsanordnung weist als Ausgangsstufe einen npn-Transistor auf, dessen Emitter mit einem Masseanschluß verbunden ist und dessen Kollektor mit einem Open-Collector-Ausgang der Schaltungsanordnung, an dem eine Ausgangsspannung ansteht, verbunden ist. Der Open-Collector-Ausgang kann dabei mit Open-Collector-Ausgängen von weiteren Schaltungsanordnungen und über einen Widerstand mit einem versorgungsanschluß, dem eine Versorgungsspannung zugeführt wird, verbunden sein.

Aus der Literaturstelle Millman/Grabel: "Microelectronics", McGraw-Hill, New York, 1988, Seite 180, ist weiterhin bekannt, daß der Kollektorbereich eines npn-Transistors in einem integrierten Schaltkreis durch eine p-dotierte Separationszone von weiteren Schaltungsteilen der Schaltungsanordnung isoliert sein kann. Der wesentliche Nachteil dieser Schaltungsanordnung besteht darin, daß der Kollektorbereich des Open-Collector-Transistors und die Separationszone eine parasitäre Diode bilden, welche leitend werden kann und somit parasitäre Ströme führen kann. Derartige parasitäre Effekte können zur Zerstörung oder Fehlfunktion der Schaltungsanordnung führen.

US-A-4 965 466 zeigt eine Schaltung der Eingangs genannten Art, wobei :
- der Kollektor des Open-Collector-Transistors mit dem Open-Collector-Ausgang der Schaltungsanordnung und über eine bei positiven Spannungswerten der Ausgangsspannung in Sperrichtung geschaltete parasitäre Diode mit dem Masseanschluß der Schaltungsanordnung verbunden ist und
- eine mit der Basis des Open-Collector-Transistors verbundene Basisstromquelle zur Erzeugung eines den Open-Collector-Transistor ansteuernden Basisstromes vorgesehen ist, wobei der Open-Collector-Transistor bei einen negativen Schwellspannungswert unterschreitenden Spannungswerten der Ausgangsspannung durch den Basisstrom in einen invers leitenden Zustand geschaltet wird, in welchem der Kollektorstrom so groß ist, daß die parasitäre Diode in Sperrichtung geschaltet verbleibt.

Der Erfindung liegt daher die Aufgabe zugrunde, eine Schaltungsanordnung gemäß dem Oberbegriff des Patentanspruchs 1 anzugeben, die mit einfachen Mitteln herstellbar ist und die hinsichtlich parasitärer Effekte verbesserte Eigenschaften aufweist.

Die Aufgabe wird durch den Gegenstand des Patentanspruchs 1 gelöst. Vorteilhafte Ausgestaltungen und Weiterbildungen ergeben sich aus den Unteransprüchen.

Erfindungsgemäß ist der Kollektor des Open-Collector-Transistors über einen, vorzugsweise niederohmig ausgeführten, Kollektorwiderstand mit dem Open-Collector-Ausgang der Schaltungsanordnung, an dem die Ausgangsspannung ansteht, und über eine parasitäre Diode mit dem Masseanschluß der Schaltungsanordnung, an dem ein Bezugspotential anliegt, verbunden. Die parasitäre Diode ist dabei aus dem Kollektorbereich des Open-Collector-Tranistors und aus einer diesen Kollektorbereich umgebenden p-dotierten Separationszone, welche zur Isolation des Open-Collector-Transistors von weiteren Schaltungsteilen der Schaltungsanordnung vorgesehen ist, gebildet. Sie ist bei positiven Spannungswerten der Ausgangsspannung in Sperrichtung geschaltet, d. h. sie ist kathodenseitig mit dem Kollektor des Open-Collector-Transistors und anodenseitig mit dem Masseanschluß der Schaltungsanordnung verbunden. Der Open-Collector-Transistor ist durch einen Basisstrom, welcher von einer mit der Basis des Open-Collector-Transistors verbundenen Basisstromquelle erzeugt wird, ansteuerbar. Er wird bei positiven Spannungswerten der Ausgangsspannung in vorwärtsrichtung und bei negativen Spannungswerten der Ausgangsspannung in Rückwärtsrichtung betrieben, wobei er bei einen negativen Schwellspannungswert unterschreitenden Spannungswerten der Ausgangsspannung durch den Basisstrom in einen invers leitenden Zustand geschaltet wird, in welchem am Kollektorwiderstand eine Spannung abfällt, die aufgrund eines dann durch den Kollektorwiderstand fließenden Kollektorstromes des Open-Collector-Transistors so groß ist, daß die parasitäre Diode in Sperrichtung geschaltet verbleibt.

Die Basisstromquelle weist vorzugsweise eine mit der Basis des Open-Collector-Transistors verbundene Steuerstromquelle auf, welche über ein an einem Schalteingang der Steuerstromquelle anliegendes Schaltsignal schaltbar ist. Der Open-Collector-Transistor ist bei positiven Spannungswerten am Open-Collector-Ausgang durch Schalten der Steuerstromquelle ein- und ausschaltbar, d. h. zwischen einem niederohmigen Zustand und einem höherohmigen Zustand umschaltbar.

In einer vorteilhaften Ausgestaltung der Schaltungsanordnung weist die Basisstromquelle einen ersten Steuertransistor und eine mit dessen Kollektor verbundene erste Ruhestromquelle auf. Der erste Steuertransistor und der Open-Collector-Transistor sind dabei als Stromspiegelanordnung mit der ersten Ruhestromquelle als Referenzstromquelle verschaltet. Die Basisstromquelle weist zur niederohmigen Einkopplung des Basisstromes einen zweiten Steuertransistor auf, dessen Basis mit dem Kollektor des ersten Steuertransistors verbunden ist, dessen Emitter mit der Basis des ersten Steuertransistors verbunden ist und dessen Kollektor mit einem versorgungsanschluß der Schaltungsanordnung, an dem eine versorgungsspannung anliegt, verbunden ist. Sie weist zur Ansteuerung des zweiten Steuertransistors vorzugsweise einen dritten Steuertransistor auf, der mit dem zweiten Steuertransistor als Darlington-Stufe verschaltet ist.

Als besonders vorteilhaft erweist es sich mittels einer Komparatorstufe ein Begrenzungssignal zur erzeugen, durch welches der Basisstrom bei einen Schwellstromwert überschreitenden Stromwerten des Kollektorstromes reduzierbar ist. Der Kollektorstrom ist auf diese Weise auf unterhalb des Schwellwertes liegende Stromwerte begrenzbar. Vorzugsweise weist die Komparatorstufe zwei mit jeweils einem Anschluß des Kollektorwiderstandes verbundene Komparatoreingänge und einen Komparatorausgang auf, an welchem das Begrenzungssignal ansteht. Dieses Begrenzungssignal wird einem mit dem Komparatorausgang der Komparatorstufe verbundenen Steuereingang der Basisstromquelle, über den der Basisstrom steuerbar ist, zugeführt.

Die vorgestellte schaltungsanordnung vereinigt mehrere vorteile in sich:
- sie weist eine geringe Anzahl von Schaltungselementen auf und ist daher kostengünstig in einen integrierten Schaltkreis integrierbar,
- sie weist eine hohe Spannungsfestigkeit für negative Spannungswerte der Ausgangsspannung auf: die Spannungswerte der Ausgangsspannung am Open-Collector-Ausgang dürfen das am Masseanschluß anliegende Bezugspotential um mehr als eine Diodenflußspannung unterschreiten, wobei der zulässige wertebereich der Ausgangsspannung durch den Kollektorwiderstand und den Kollektorstrom vorgebbar ist,
- sie weist aufgrund der Begrenzung des Kollektorstromes eine hohe Kurzschlußfestigkeit auf,
- die Spannungswerte der Ausgangsspannung sind bei eingeschaltetem und in Vorwärtsrichtung betriebenem Open-Collector-Transistor gering.

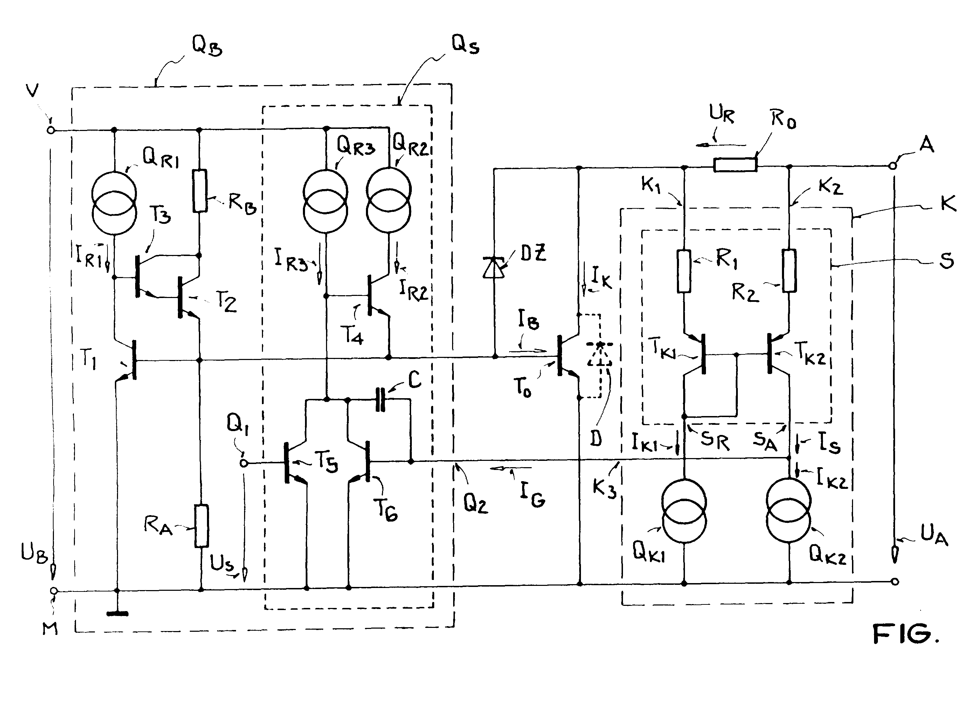

Die erfindungsgemäße Schaltungsanordnung wird im folgenden anhand eines in der Figur gezeigten Ausführungsbeispiels näher beschrieben.

Gemäß der Figur ist der Kollektor des Open-Collector-Transistors To über den Kollektorwiderstand R₀, an dem die Spannung U_{R} abfällt, mit dem Open-Collector-Ausgang A der Schaltungsanordnung, an dem die Ausgangsspannung U_{A} ansteht, verbunden, der Emitter des Open-Collector-Transistors T₀ mit dem Masseanschluß M der Schaltungsanordnung, an dem ein Bezugspotential anliegt, verbunden und die Basis des Open-Collector-Transistors T₀ mit der Basisstromquelle Q_{B}, die den Basisstrom l_{B} zur Steuerung des Open-Collector-Transistors T₀ liefert, verbunden. Die Zenerdiode DZ, die kathodenseitig mit dem Kollektor und anodenseitig mit der Basis des Open-Collector-Transistors T₀ verbunden ist, dient zum Schutz des Open-Collector-Transistors T₀ vor zu hohen Kollektor-Emitter-Spannungen. Die gesamte Schaltungsanordnung ist auf ein Halbleitersubstrat eines integrierten Schaltkreises integriert, wobei auch weitere, in der Figur nicht gezeigte, Schaltungsteile auf das gleiche Halbleitersubstrat integriert sein können. Der Kollektor des Open-Collector-Transistors T₀ ist dabei von einer p-dotierten und mit dem Masseanschluß M verbundenen Separationszone umgeben und durch diese von weiteren n-dotierten Halbleiterbereichen isoliert. Die Separationszone und der Kollektorbereich des Open-Collector-Transistors T₀ bilden dabei die durch gestrichelte Linien angedeutete parasitäre Diode D.

Die Basisstromquelle Q_{B} umfaßt die Steuerstromquelle Q_{S}, die erste Ruhestromquelle Q_{R1}, den ersten Steuertransistor T₁, den zweite Steuertransistor T₂, den dritten Steuertransistor T₃, den Begrenzungswiderstand R_{B} und den Ableitwiderstand R_{A}. Der Emitter des ersten Steuertransistors T₁ ist mit dem Masseanschluß M verbunden, der Kollektor des ersten Steuertransistors T₁ ist mit der Basis des dritten Steuertransistors T₃ und über die erste Ruhestromquelle Q_{R1} mit dem Versorgungsanschluß V, dem die Versorgungsspannung U_{B} zugeführt wird, verbunden, die Kollektoren des zweiten und des dritten Steuertransistors T₂ und T₃ sind über den Begrenzungswiderstand R_{B} mit dem versorgungsanschluß V verbunden und die Basis des ersten Steuertransistors T₁ ist mit dem Emitter des zweiten Steuertransistors T₂, mit der Basis des Open-Collector-Transistors T₀ und über den Ableitwiderstand R_{A} mit dem Masseanschluß M verbunden. Der Ableitwiderstand R_{A} dient dabei zur Einstellung eines definierten Potentials an der Basis des ersten Steuertransistors T₁ und der Begrenzungswiderstand R_{B} dient zur Begrenzung des durch den zweiten Steuertransistor T₂ fließenden Stromes.

Die Steuerstromquelle Q_{S} umfaßt die zweite Ruhestromquelle Q_{R2}, die dritte Ruhestromquelle Q_{R3}, den vierten Steuertransistor T₄, den fünften Steuertransistor T₅, den sechsten Steuertransistor T₆ und den Kondensator C. Dabei ist der Emitter des vierten Steuertransistors T₄ mit der Basis des Open-Collector-Transistors T₀ verbunden, der Kollektor des vierten Steuertransistors T₄ über die zweite Ruhestromquelle Q_{R2} mit dem Versorgungsanschluß v verbunden, die Basis des vierten Steuertransistors T₄ mit den Kollektoren des fünften und sechsten Steuertransistors T₅ und T₆, über den Kondensator C mit dem Steuereingang O₂ der Basisstromquelle Q_{B} sowie über die dritte Ruhestromquelle Q_{R3} mit dem Versorgungsanschluß V verbunden. Die Basis des fünften Steuertransistors T₅ ist mit dem Schaltanschluß Q₁ der Steuerstromquelle Q_{S}, an dem eine Spannung als Schaltsignal U_{S} zum Schalten der Steuerstromquelle Q_{S} ansteht, verbunden und die Basis des sechsten Steuertransistors T₆ ist mit dem Steuereingang Q₂ der Basisstromquelle Q_{B}, der gleichzeitig einen Steuereingang der Steuerstromquelle Q_{S} bildet und an dem ein Strom als Begrenzungssignal I_{G} ansteht, verbunden.

Die Komparatorstufe K umfaßt die beiden Komparatorwiderstände R₁, R₂, die beiden Komparatortransistoren T_{K1}, T_{K2} und die beiden Konstantstromquellen Q_{K1}, Q_{K2}. Der Emitter des einen Komparatortransistors T_{K1} ist über den einen Komparatorwiderstand R₁ mit dem einen Komparatoreingang K₁ der Komparatorstufe K und mit einem, an den Kollektor des Open-Collector-Transistors T₀ angeschlossenen, Anschluß des Kollektorwiderstandes R₀ verbunden, der Emitter des anderen Komparatortransistors T_{K2} ist über den anderen Komparatorwiderstand R₂ mit einem weiteren, an den Open-Collector-Ausgang A angeschlossenen, Anschluß des Kollektorwiderstandes R₀ verbunden, die Basen der Komparatortransistoren T_{K1}, T_{K2} sind mit dem Kollektor des einen Komparatortransistors T_{K1} und über die eine Konstantstromquelle Q_{K1} mit dem Masseanschluß M verbunden und der Kollektor des anderen Komparatortransistors T_{K2} ist mit dem Komparatorausgang K₃, der an den Steuereingang Q₂ der Basisstromquelle Q_{B} angeschlossen ist, und über die andere Konstantstromquelle Q_{K2} mit dem Masseanschluß M verbunden. Die beiden Komparatorwiderstände R₁, R₂ und die beiden Komparatortransistoren T_{K1}, T_{K2} bilden daher eine Stromspiegelanordnung S mit dem Kollektor des einen Komparatortransistors T_{K1} als Referenzstromeingang S_{R}, am dem der Strom I_{K1} der einen Konstantstromquelle Q_{K1} als Referenzstrom ansteht, und mit dem Kollektor des anderen Komparatortransistors T_{K2} als Spiegelstromausgang S_{A}, an dem der spiegelstrom l_{S} ansteht.

Die Steuertransistoren T₁, T₂, T₃, T₄, T₅, T₆ und der Open-Collector-Transistor T₀ sind als npn-Transistoren und die Komparatortransistoren T_{K1}, T_{K2} als pnp-Transistoren ausgeführt. Der Open-Collector-Transistor T₀ wird daher bei positiven Spannungswerten der Ausgangsspannung U_{A}, d. h. bei bezüglich dem Bezugspotential am Masseanschluß M positiven Potentialen am Open-Collector-Ausgang A, in vorwärtsrichtung betrieben. Er ist dann bei einem dem Bezugspotential entsprechenden Low-Pegel des Schaltsignals U_{S} eingeschaltet und bei einem, beispielsweise der versorgungsspannung U_{B} entsprechenden, High-Pegel des Schaltsignals U_{S} ausgeschaltet.

Beim High-Pegel des Schaltsignals U_{S} ist der fünfte Steuertransistor T₅ leitend und führt somit den gesamten von der dritten Ruhestromquelle Q_{R3} lieferbaren Strom I_{R3} zum Masseanschluß M ab. Der vierte Steuertransistor T₄ und die Steuerstromquelle Q_{S} sind folglich gesperrt und liefern daher keinen Beitrag zum Basisstrom I_{B}. Der Basisstrom I_{B} ist jedoch nicht gleich Null, da die Steuertransistoren T₁, T₂ und T₃ und der Open-Collector-Transistor T₀ als Stromspiegelanordnung wirken, mit der der Strom I_{R1} der ersten Ruhestromquelle Q_{R1} als Kollektorstrom I_{K} des Open-Collector-Transistors T₀ zum Open-Collector-Ausgang A gespiegelt wird. Das Spiegelverhältnis - das Verhältnis aus dem Kollektorstrom I_{K} des open-Collector-Transistors T₀ und dem Strom I_{R1} der ersten Ruhestromquelle Q_{R1}-ist durch das Verhältnis aus der Emitterfläche des Open-Collector-Transistors T₀ und der Emitterfläche des ersten Steuertransistors T₁ auf einen Wert von beispielsweise 20 festgelegt. Bei einem Strom I_{R1} der ersten Ruhestromquelle Q_{R1} von beispielsweise 75 µA beträgt der Kollektorstrom I_{K} dann 1,5 mA. Dieses ist der minimale durch den Open-Collector-Transistor T₀ fließende Kollektorstrom I_{K}, d. h. der Open-Collector-Transistor T₀ ist im ausgeschalteten Zustand nicht vollständig sperrend, sondern er befindet sich lediglich in einem höherohmigen Zustand als im eingeschalteten Zustand.

Bei einem Low-Pegel des Schaltsignals U_{S} ist der fünfte Steuertransistor T₅ gesperrt, so daß der Strom I_{R3} der dritten Ruhestromquelle Q_{R3} der Basis des vierten Steuertransistors T₄ zugeführt wird. Dieser ist daher leitend und leitet folglich den Strom I_{R2} der zweiten Ruhestromquelle Q_{R2}, der beispielsweise etwa 3 mA beträgt, zur Basis des Open-Collector-Transistors T₀, welcher hierdurch eingeschaltet, d. h. in einen niederohmigen Zustand geschaltet wird. Falls dem Steuereingang Q₂ gleichzeitig das Begrenzungssignal l_{C} zugeführt wird, wird ein Teil des Stromes I_{R3} der dritten Ruhestromquelle Q_{R3} über den sechsten Steuertransistor T₆ zum Masseanschluß M abgeleitet, so daß nur noch ein Teil des von der zweiten Ruhestromquelle Q_{R2} lieferbaren Stromes I_{R2} über den vierten Steuertransistor T₄ der Basis des Open-Collector-Transistors T₀ zugeführt werden kann, d. h. der Basisstrom I_{B} und folglich auch der Kollektorstrom I_{K} werden durch das Begrenzungssignal I_{G} reduziert.

Die Widerstandswerte des Kollektorwiderstandes R₀ und der Komparatorwiderstände R₁, R₂ sind derart gewählt, daß der Strom I_{K1} der einen Konstantstromquelle Q_{K1} und der Spiegelstrom I_{S} der Stromspiegelanordnung S dann gleich sind, wenn der Kollektorstrom I_{K} des Open-Collector-Transistors T₀ gleich einem Schwellstromwert von beispielsweise 80 mA ist. Bei einem Widerstandswert des Kollektorwiderstandes R₀ von beispielsweise 3 Ω beträgt der eine Komparatorwiderstand R₁ beispielsweise 2 kΩ und der andere Komparatorwiderstand R₂ 11,6 kΩ. Die beiden Konstantstromquellen Q_{K1}, Q_{K2} liefern lediglich geringe Ströme I_{K1}, I_{K2}, die gleich sind und beispielsweise jeweils 25 µA betragen, so daß die Schaltungsanordnung durch die Komparatorstufe K nur geringfügig belastet wird. Bei einem den Schwellstromwert überschreitenden Stromwert des Kollektorstromes I_{K} ist der Spannungsabfall zwischen dem Open-Collector-Ausgang A und dem Emitter des einen Komparatortransistors T_{K1} größer als der Spannungsabfall zwischen dem Open-Collector-Ausgang A und dem Emitter des anderen Komparatortransistors T_{K2}. Folglich ist auch der Spiegelstrom I_{S} größer als der Strom I_{K1} der einen Konstantstromquelle Q_{K1}. Der den Strom I_{K2} der zweiten Konstantstromquelle Q_{K2} überschreitende Anteil des Spiegelstromes I_{S} wird dann als Begrenzungssignal I_{G} dem Steuereingang Q₂ der Basisstromquelle Q_{B} zugeführt. Der Kollektorstrom I_{K} wird daraufhin durch Reduzierung des Basisstromes I_{B} auf einen unterhalb des Schwellstromwerts liegenden Stromwert begrenzt. Der Kondensator C verhindert dabei, daß die Schaltungsanordnung hierdurch zum Schwingen angeregt wird.

Der Open-Collector-Transistor T₀ wird bei negativen Spannungswerten der Ausgangsspannung U_{A} in Rückwärtsrichtung, d. h. invers betrieben. Er wird bei Spannungswerten der Ausgangsspannung U_{A}, die eine negative Schwellwertspannung, welche um eine Diodenflußspannung (0,7 V) kleiner als das Bezugspotential ist, unterschreiten, in einen invers leitenden Zustand geschaltet. Der Kollektorstrom I_{K} fließt dann vom Kollektor des Open-Collector-Transistors T₀ durch den Kollektorwiderstand R₀ zum Open-Collector-Ausgang A, so daß er Open-Collector-Transistor T₀ und die Steuertransistoren T₁, T₂, T₃ nicht mehr als Stromspiegelanordnung wirken. Da die parasitäre Diode D sperrend sein soll, muß die am Kollektorwiderstand R₀ abfallende Spannung U_{R} so groß sein, daß sich am Kollektor der Open-Collector-Transistors T₀ ein Potential einstellt, welches das Bezugspotential am Masseanschluß M und folglich auch das Potential an der Separationszone um weniger als eine Diodenflußspannung unterschreitet. Der Kollektorstrom I_{K} muß, da die Spannung U_{R} von ihm abhängig ist, entsprechend groß ausgelegt sein. Die parasitäre Diode D ist dann für alle Spannungswerte der Ausgangsspannung U_{A}, die innerhalb eines zulässigen Wertebereichs von beispielsweise -1 V bis 29 V liegen, in Sperrichtung geschaltet. Der kleinste wert des zulässigen Wertebereichs ist dabei durch den Kollektorstrom I_{K} und den Kollektorwiderstand R₀ vorgegeben. Der Kollektorwiderstand R₀ darf jedoch, da die Ausgangsspannung U_{A} bei in Vorwärtsrichtung leitendem Open-Collector-Transistor T₀ einen Maximalwert von beispielsweise 0,5 V nicht überschreiten soll, nicht zu groß dimensioniert sein. Daher muß der Kollektorstrom I_{K} durch die Wahl eines ausreichend großen Basisstromes I_{B} entsprechend groß ausgelegt sein. Die Stromverstärkung des Open-Collector-Transistors T₀ ist beim Betrieb in Rückwärtsrichtung wesentlich kleiner als beim Betrieb in Vorwärtsrichtung. Demzufolge wird beispielsweise zur Erzeugung eines Kollektorstromes I_{K} von -200 mA ein Basisstrom I_{B} von ca. 20 mA benötigt. Bei einer Ausgangsspannung U_{A} von -1 V und einem Kollektorwiderstand R₀ von 3 Ω erhält man dann am Kollektor des Open-Collector-Transistors T₀ ein Potential von -0,4 V, d. h. die parasitäre Diode D bleibt gesperrt. Die Basis-Kollektor-Diode des Open-Collector-Transistors T₀ ist hingegen leitend, so daß der erste Steuertransistor T₁, an dessen Basis folglich ein Potential von ca. 0,3 V anliegt, gesperrt ist. Daher wird der gesamte Strom I_{R1} der ersten Ruhestromquelle Q_{R1} zu der aus dem zweiten und dritten Steuertransistor T₂, T₃ gebildeten Darlington-Stufe geführt und durch diese um ein Vielfaches verstärkt. Dieser um ein Vielfaches auf ca. 20 mA verstärkte Strom, der von der versorgungsspannung U_{S} geliefert wird, wird durch den Widerstand R_{B} begrenzt und dann der Basis des Open-Collector-Transistors T₀ als Basisstrom l_{B} zugeführt.

## Patentansprüche

1. Integrierte Schaltungsanordnung mit einem als npn-Transistor ausgebildeten Open-Collector-Transistor (T₀), dessen Kollektor mit einem Open-Collector-Ausgang (A) der Schaltungsanordnung verbundenen ist und dessen Emitter mit einem Masseanschluß (M) der Schaltungsanordnung verbundenen ist, wobei am Open-Collector-Ausgang (A) eine Ausgangsspannung (U_{A}) ansteht, wobei
- der Kollektor des Open-Collector-Transistors (T₀) über einen Kollektorwiderstand (R₀) mit dem Open-Collector-Ausgang (A) der Schaltungsanordnung und über eine bei positiven Spannungswerten der Ausgangsspannung (U_{A}) in Sperrichtung geschaltete parasitäre Diode (D) mit dem Masseanschluß (M) der Schaltungsanordnung verbunden ist und
- eine mit der Basis des Open-Collector-Transistors (T₀) verbundene Basisstromquelle (Q_{B}) zur Erzeugung eines den Open-Collector-Transistor (T₀) ansteuernden Basisstromes (I_{B}) vorgesehen ist, wobei der Open-Collector-Transistor (T₀) bei einen negativen Schwellspannungswert unterschreitenden Spannungswerten der Ausgangsspannung (U_{A}) durch den Basisstrom (I_{B}) in einen invers leitenden Zustand geschaltet wird, in welchem am Kollektorwiderstand (R₀) eine Spannung (U_{R}) abfällt, die so groß ist, daß die parasitäre Diode (D) in Sperrichtung geschaltet verbleibt.

2. Schaltungsanordnung nach Anspruch 1, dadurch gekennzeichnet, daß der Kollektorwiderstand (R₀) niederohmig ausgeführt ist.

3. Schaltungsanordnung nach Anspruch 1 oder 2, dadurch gekennzeichnet, daß die Basisstromquelle (Q_{B}) eine mit der Basis des Open-Collector-Transistors (T₀) verbundene Steuerstromquelle (Q_{S}) aufweist, die über ein an einem Schalteingang (Q₁) der Steuerstromquelle (Q_{S}) anliegendes Schaltsignal (U_{S}) schaltbar ist.

4. Schaltungsanordnung nach einem der vorherigen Ansprüche, dadurch gekennzeichnet, daß die Basisstromquelle (Q_{B}) eine erste Ruhestromquelle (Q_{R1}) und einen ersten Steuertransistor (T₁) aufweist, wobei der Kollektor und die Basis des ersten Steuertransistors (T₁) miteinander verbunden sind, der Kollektor des ersten Steuertransistors (T₁) mit der ersten Ruhestromquelle (Q_{R1}) verbunden ist, der Emitter des ersten Steuertransistors (T₁) mit dem Masseanschluß (M) der Schaltungsanordnung verbunden ist und die Basis des ersten Steuertransistors (T₁) mit der Basis des Open-Collector-Transistors (T₀) verbunden ist.

5. Schaltungsanordnung nach Anspruch 4, dadurch gekennzeichnet, daß der Kollektor und die Basis des ersten Steuertransistors (T₁) über einen zweiten Steuertransistor (T₂) miteinander verbunden sind, wobei die Basis des zweiten Steuertransistors (T₂) mit dem Kollektor des ersten Steuertransistors (T₁) verbunden ist, der Emitter des zweiten Steuertransistors (T₂) mit der Basis des ersten Steuertransistors (T₁) verbunden ist und der Kollektor des zweiten Steuertransistors (T₂) mit einem Versorgungsanschluß (V) der Schaltungsanordnung, am dem eine Versorgungsspannung (U_{B}) anliegt, verbunden ist.

6. Schaltungsanordnung nach Anspruch 5, dadurch gekennzeichnet, daß der Kollektor des ersten Steuertransistors (T₁) und die Basis des zweiten Steuertransistors (T₂) über einen dritten Steuertransistor (T₃) miteinander verbunden sind, wobei die Basis des dritten Steuertransistors (T₃) mit dem Kollektor des ersten Steuertransistors (T₁) verbunden ist und der Kollektor des zweiten Steuertransistors (T₂) über die Kollektor-Emitter-Strecke des dritten Steuertransistors (T₃) mit der Basis des zweiten Steuertransistors (T₂) verbunden ist.

7. Schaltungsanordnung nach einem der vorherigen Ansprüche, dadurch gekennzeichnet, daß die Basisstromquelle (Q_{B}) einen Steuereingang (Q₂) für ein Begrenzungssignal (I_{G}) zur Reduzierung des Basisstromes (I_{B}) aufweist.

8. Schaltungsanordnung nach Anspruch 7, dadurch gekennzeichnet, daß eine Komparatorstufe (K) zur Erzeugung des Begrenzungssignals (I_{G}) vorgesehen ist, wobei der Basisstrom (I_{B}) durch das Begrenzungssignal (I_{G}) zur Begrenzung eines am Kollektor des Open-Collector-Transistor (T₀) anstehenden Kollektorstromes (I_{K}) bei einen Schwellstromwert überschreitenden Stromwerten des Kollektorstromes (I_{K}) reduzierbar ist.

9. Schaltungsanordnung nach Anspruch 8, dadurch gekennzeichnet, daß die Komparatorstufe (K) zwei mit jeweils einem Anschluß des Kollektorwiderstandes (R₀) verbundene Komparatoreingänge (K₁, K₂) und einen mit dem Steuereingang (Q₂) der Basisstromquelle (Q_{B}) verbundenen Komparatorausgang (K₃), an dem das Begrenzungssignal (I_{G}) ansteht, aufweist.

10. Schaltungsanordnung nach Anspruch 9, dadurch gekennzeichnet, daß die Komparatorstufe (K) zwei Komparatorwiderstände (R₁, R₂) zwei Konstantstromquellen (Q_{K1}, Q_{K2}) und zwei als Stromspiegelanordnung (S) verschaltete Komparatortransistoren (T_{K1}, T_{K2}) mit dem Kollektor des einen Komparatortransistors (T_{K1}) als Referenzstromeingang (S_{R}) der Stromspiegelanordnung (S) und dem Kollektor des anderen Komparatortransistors (T_{K2}) als Spiegelstromausgang (S_{A}) der Stromspiegelanordnung (S) aufweist, wobei die Emitter der Komparatortransistoren (T_{K1}, T_{K2}) jeweils über einen der Komparatorwiderstände (R₁, R₂) mit einem der Komparatoreingänge (K₁, K₂) verbunden sind, die Kollektoren der Komparatortransistoren (T_{K1}, T_{K2}) jeweils mit einer der Konstantstromquellen (Q_{K1}, Q_{K2}) verbunden sind und der Spiegelstromausgang (S_{A}) der Stromspiegelanordnung (S) mit dem Komparatorausgang (K₃) verbunden ist.

11. Schaltungsanordnung nach einem der Ansprüche 7 bis 10, wenn abhängig von Anspruch 3, dadurch gekennzeichnet, daß die Steuerstromquelle (Q_{S}) eine zweite Ruhestromquelle (Q_{R2}), eine dritte Ruhestromquelle (Q_{R3}), einen vierten Steuertransistor (T₄), einen fünften Steuertransistor (T₅) und einen sechsten Steuertransistor (T₆) aufweist, wobei die zweite Ruhestromquelle (Q_{R2}) über die Kollektor-Emitter-Strecke des vierten Steuertransistors (T₄) mit der Basis des Open-Collector-Transistors (T₀) verbunden ist, die dritte Ruhestromquelle (Q_{R3}) mit der Basis des vierten Steuertransistors (T₄) und mit den Kollektoren des fünften und sechsten Steuertransistors (T₅, T₆) verbunden ist, die Basis des fünften Steuertransistors (T₅) mit dem Schalteingang (Q₁) der Steuerstromquelle (Q_{S}) verbunden ist, die Basis des sechsten Steuertransistors (T₆) mit dem Steuereingang (Q₂) der Basisstromquelle (Q_{B}) verbunden ist und die Emitter des fünften und sechsten Steuertransistors (T₅, T₆) mit dem Masseanschluß (M) der Schaltungsanordnung verbunden sind.

## Claims

1. Integrated circuit arrangement with an open-collector transistor (T₀) which is formed as an n-p-n transistor, the collector of which is connected to an open-collector output (A) of the circuit arrangement and the emitter of which is connected to an earth connection (M) of the circuit arrangement, wherein an output voltage (U_{A}) is present at the open-collector output (A), wherein
- the collector of the open collector transistor (T₀) is connected to the open-collector output (A) of the circuit arrangement via a collector resistor (R₀) and to the earth connection (M) of the circuit arrangement via a parasitic diode (D), which is reverse biased when the output voltage (U_{A}) has positive voltage values, and
- a base current source (Q_{B}), which is connected to the base of the open-collector transistor (T₀), is provided to generate a base current (I_{B}) driving the open-collector transistor (T₀), wherein the open-collector transistor (T₀) is switched by the base current (I_{B}) into an inversely conducting state when the output voltage (U_{A}) has voltage values falling below a negative threshold voltage value, in which state a voltage (U_{R}) drops at the collector resistor (R₀), which voltage is of a magnitude such that the parasitic diode (D) remains reverse biased.

2. Circuit arrangement according to Claim 1, characterised in that the collector resistor (R₀) is of a low-resistance type.

3. Circuit arrangement according to Claim 1 or 2, characterised in that the base current source (Q_{B}) comprises a control current source (Q_{S}) which is connected to the base of the open-collector transistor (T₀) and can be switched via a switching signal (U_{S}) applied to a switching input (Q₁) of the control current source (Q_{S}).

4. Circuit arrangement according to any one of the preceding Claims, characterised in that the base current source (Q_{B}) comprises a first quiescent current source (Q_{R1}) and a first control transistor (T₁), wherein the collector and the base of the first control transistor (T₁) are connected together, the collector of the first control transistor (T₁) is connected to the first quiescent current source (Q_{R1}), the emitter of the first control transistor (T₁) is connected to the earth connection (M) of the circuit arrangement, and the base of the first control transistor (T₁) is connected to the base of the open-collector transistor (T₀).

5. Circuit arrangement according to Claim 4, characterised in that the collector and the base of the first control transistor (T₁) are connected together via a second control transistor (T₂), wherein the base of the second control transistor (T₂) is connected to the collector of the first control transistor (T₁), the emitter of the second control transistor (T₂) is connected to the base of the first control transistor (T₁), and the collector of the second control transistor (T₂) is connected to a supply terminal (V) of the circuit arrangement, to which terminal a supply voltage (U_{B}) is applied.

6. Circuit arrangement according to Claim 5, characterised in that the collector of the first control transistor (T₁) and the base of the second control transistor (T₂) are connected together via a third control transistor (T₃), wherein the base of the third control transistor (T₃) is connected to the collector of the first control transistor (T₁), and the collector of the second control transistor (T₂) is connected to the base of the second control transistor (T₂) via the collector-emitter path of the third control transistor (T₃).

7. Circuit arrangement according to any one of the preceding Claims, characterised in that the base current source (Q_{B}) comprises a control input (Q₂) for a limiting signal (I_{G}) for reducing the base current (I_{B}).

8. Circuit arrangement according to Claim 7, characterised in that a comparator stage (K) is provided for generating the limiting signal (I_{G}), wherein the base current (I_{B}) can be reduced by the limiting signal (I_{G}) for limiting a collector current (I_{K}) present at the collector of the open-collector transistor (T₀) when the current values of the collector current (I_{K}) exceed a threshold current value.

9. Circuit arrangement according to Claim 8, characterised in that the comparator stage (K) comprises two comparator inputs (K₁, K₂), which are connected to a respective terminal of the collector resistor (R₀), and a comparator output (K₃), which is connected to the control input (Q₂) of the base current source (Q_{B}) and at which the limiting signal (I_{G}) is present.

10. Circuit arrangement according to Claim 9, characterised in that the comparator stage (K) comprises two comparator resistors (R₁, R₂), two constant-current sources (Q_{K1}, Q_{K2}) and two comparator transistors (T_{K1}, T_{K2}), which are connected as a current mirror arrangement (S), with the collector of one comparator transistor (T_{K1}) as reference current input (S_{R}) of the current mirror arrangement (S) and the collector of the other comparator transistor (T_{K2}) as mirror current output (S_{A}) of the current mirror arrangement (S), wherein the emitters of the comparator transistors (T_{K1}, T_{K2}) are each connected to one of the comparator inputs (K₁, K₂) via one of the comparator resistors (R₁, R₂), the collectors of the comparator transistors (T_{K1}, T_{K2}) are each connected to one of the constant-current sources (Q_{K1}, Q_{K2}), and the mirror current output (S_{A}) of the current mirror arrangement (S) is connected to the comparator output (K₃).

11. Circuit arrangement according to any one of Claims 7 to 10, if dependent on Claim 3, characterised in that the control current source (Q_{S}) comprises a second quiescent current source (Q_{R2}), a third quiescent current source (Q_{R3}), a fourth control transistor (T₄), a fifth control transistor (T₅) and a sixth control transistor (T₆), wherein the second quiescent current source (Q_{R2}) is connected to the base of the open-collector transistor (T₀) via the collector-emitter path of the fourth control transistor (T₄), the third quiescent current source (Q_{R3}) is connected to the base of the fourth control transistor (T₄) and to the collectors of the fifth and the sixth control transistor (T₅, T₆), the base of the fifth control transistor (T₅) is connected to the switching input (Q₁) of the control current source (Q_{S}), the base of the sixth control transistor (T₆) is connected to the control input (Q₂) of the base current source (Q_{B}), and the emitters of the fifth and the sixth control transistor (T₅, T₆) are connected to the earth connection (M) of the circuit arrangement.

## Revendications

1. Montage intégré comportant un transistor à collecteur ouvert (T₀), qui est agencé sous la forme d'un transistor npn, dont le collecteur est relié à une sortie à collecteur ouvert (A) du montage et dont l'émetteur est relié à une borne de masse (M) du montage, une tension de sortie (U_{A}) étant présente sur la sortie à collecteur ouvert (A), et dans lequel
- le collecteur du transistor (T₀) à collecteur ouvert est relié par l'intermédiaire d'une résistance de collecteur (R₀) à la sortie à collecteur ouvert (A) du montage et, par l'intermédiaire d'une diode parasite (D) branchée dans le sens bloquant pour des valeurs positives de la tension de sortie (U_{A}), à la borne de masse (M) du montage, et
- qu'il est prévu une source de courant de base (Q_{B}), qui est reliée à la masse du transistor à collecteur ouvert (T₀) et qui sert à produire un courant de base (I_{B}) commandant le transistor à collecteur ouvert (T₀), le transistor à collecteur ouvert (T₀) étant placé dans un état de conduction inverse pour des valeurs de la tension de sortie (U_{A}) dépassant la valeur de seuil négative de tension, état dans lequel une tension (U_{R}), qui est suffisamment élevée pour que la diode parasite (D) reste branchée dans le sens bloquant chute aux bornes de la résistance du collecteur R₀).

2. Montage selon la revendication 1, caractérisé en ce que la résistance de collecteur (R₀) est réalisée avec une faible valeur ohmique.

3. Montage selon la revendication 1 ou 2, caractérisé en ce que la source de courant de base (Q_{B}) comporte une source de courant de commande (Q_{S}), qui est reliée à la base du transistor à collecteur ouvert (T₀) et qui peut être commutée par l'intermédiaire d'un signal de commutation (U_{S}) qui est appliqué à une entrée de commutation (Q₁) de la source de courant de commande (Q_{S}).

4. Montage selon l'une des revendications précédentes, caractérisé en ce que la source de courant de base (Q_{B}) possède une source de courant de repos (Q_{R}) et un premier transistor de commande (T₁), et dans lequel le collecteur et la base du premier transistor de commande (T₁) sont reliés entre eux, le collecteur du premier transistor de commande (T₁) est relié à la première source de courant de repos (Q_{R}), l'émetteur du premier transistor de commande (T₁) est relié à la borne de masse (M) du montage et la base du premier transistor (T₁) est reliée à la base du transistor à collecteur ouvert (T₀).

5. Montage selon la revendication 4, caractérisé en ce que le collecteur et la base du premier transistor de commande (T₁) sont reliés entre eux par l'intermédiaire d'un second transistor (T₂), et dans lequel la base du second transistor (T₂) est reliée au collecteur du premier transistor (T₁), l'émetteur du second transistor (T₂) est relié à la base du premier transistor de commande (T₁), et le collecteur du second transistor (T₂) est relié à une borne d'alimentation (V) du montage, à laquelle s'applique une tension d'alimentation (Q_{B}).

6. Montage selon la revendication 5, caractérisé en ce que le collecteur du premier transistor de commande (T₁) et la base du second transistor de commande (T₂) sont reliés entre eux par l'intermédiaire d'un troisième transistor de commande (T₃), et dans lequel la base du troisième transistor de commande (T₃) est reliée au collecteur du premier transistor de commande (T₁) et le collecteur du second transistor de commande (T₂) est relié par l'intermédiaire de la voie collecteur - émetteur du troisième transistor de commande (T₁) à la base du second transistor de commande (T₂).

7. Montage selon l'une des revendications précédentes, caractérisé en ce que la source de courant de base (Q_{B}) comporte une entrée de commande (Q₂) pour un signal de limitation (I_{C}) pour réduire le courant de base (I_{B}).

8. Montage selon la revendication 7, caractérisé en ce qu'il est prévu un étage comparateur (K) pour produire le signal de limitation (I_{G}), et dans lequel le courant de base (I_{B}) peut être réduit par le signal de limitation (I_{C}) de manière à limiter un courant de collecteur (I_{K}) appliqué au collecteur du transistor à collecteur ouvert (T₀), dans le cas où des valeurs du courant de collecteur (I_{K}) dépassent une valeur de seuil du courant.

9. Montage selon la revendication 8, caractérisé en ce que l'étage comparateur (K) comporte deux entrées (K₁, K₂), qui sont reliées à des bornes respectives de la résistance de collecteur (R₀), et une sortie (K₃), qui est reliée à l'entrée de commande (Q₂) de la source de courant de base (Q_{B}) et sur laquelle est présent le signal de limitation (I_{C}).

10. Montage selon la revendication 9, caractérisé en ce que l'étage comparateur (K) comporte deux résistances (R₁, R₂), deux sources de courant constant (Q_{K1}, Q_{K2}) et deux transistors (T_{K1}, T_{K2}) branchés en tant que dispositif formant miroir de courant (S), avec le collecteur d'un transistor (T_{K1}) du comparateur en tant qu'entrée de courant de référence (S_{R}) du dispositif formant miroir de courant (S) et le collecteur de l'autre transistor (T_{K2}) du comparateur en tant que sortie (S_{R}) du courant du dispositif formant miroir de courant (S), et dans lequel les émetteurs des transistors (T_{K1}, T_{K2}) du comparateur sont reliés respectivement par l'intermédiaire de l'une des résistances (R₁,R₂) du comparateur à l'une des entrées (K₁ et K₂) du comparateur, les collecteurs des transistors (T_{K1}, T_{K2}) du comparateur sont reliés respectivement à l'une des sources de courant constant (Q_{K1}, Q_{K2}) et la sortie (S_{A}) du courant du dispositif formant miroir de courant (S) est reliée à la sortie (K₃) du comparateur.

11. Montage selon l'une des revendications 7 à 10, considérées comme dépendantes de la revendication 3, caractérisé en ce que la source de courant de commande (Q_{S}) comporte une seconde source de courant de repos (Q_{R2}), une troisième source de courant de repos (Q_{R3}), un quatrième transistor de commande (T₄), un cinquième transistor de commande (T₅) et un sixième transistor de commande (T₆), et dans lequel la deuxième source de courant résiduelle (Q_{R2}) est reliée à la base du transistor à collecteur ouvert (T₀) par l'intermédiaire de la voie collecteur - émetteur du quatrième transistor de commande (T₄), que la troisième source de courant de repos (Q_{R3}) est reliée à la base du quatrième transistor de commande (T₄) et aux collecteurs des cinquième et sixième transistors de commande (T₅, T₆), la base du cinquième transistor de commande (T₅) est reliée à l'entrée de commutation (Q₁) de la source de courant de commande (Q_{S}), la base du sixième transistor de commande (T₆) est reliée à l'entrée de commande (Q₂) de la source de courant de base (Q_{B}) et les émetteurs des cinquième et sixième transistors de commande (T₅, T₆) sont reliés à la borne de masse (M) du montage.
